**Europäisches Patentamt**

**European Patent Office**

**Office européen des brevets**

(19)

(11) Numéro de publication: **0 150 648**
**B1**

(12) FASCICULE DE BREVET EUROPEEN

(45) Date de publication du fascicule du brevet:
08.02.89

(51) Int. Cl.⁴: **H 03 B 19/18**

(21) Numéro de dépôt: **84402747.4**

(22) Date de dépôt: **27.12.84**

(54) Multiplicateur de fréquence, pour ondes millimétriques.

(30) Priorité: **27.01.84 FR 8401288**

(43) Date de publication de la demande:
07.08.85 Bulletin 85/32

(45) Mention de la délivrance du brevet:
08.02.89 Bulletin 89/6

(84) Etats contractants désignés:
**GB IT NL**

(73) Titulaire: **ALCATEL THOMSON FAISCEAUX HERTZIENS,
55, rue Greffulhe, F-92300 Levallois-Perret Cédex (FR)**

(72) Inventeur: **Mettoudi, Isaac, THOMSON-CSF
SCPI 173, bld Haussmann, F-75379 Paris Cedex 08 (FR)**

(74) Mandataire: **Weinmiller, Jürgen et al,
Lennéstrasse 9 Postfach 24, D-8133 Feldafing (DE)**

(56) Documents cités:
DE-C- 908 746
US-A- 2 408 420
US-A- 3 423 701
US-A- 3 559 074

1966 INTERNATIONAL SOLID-STATE CIRCUITS
CONFERENCE, DIGEST OF TECHNICAL PAPERS, 10
février 1966, University Museum/Univ. of Pennsylvania,
1e édition, New York, US; I.E. HEFNI et al.:
"High-efficiency ultraflat low-noise varactor frequency
converter using low-frequency pumping"
1979 IEEE MTT-S INTERNATIONAL MICROWAVE
SYMPOSIUM, DIGEST, 30 avril - 2 mai 1979, Orlando,
Florida, pages 220-221, IEEE, New York, US; R. MITTRA
et al.: "Active integrated devices on dielectric
substrates for millimeter-wave applications"

(56) Documents cités: (suite)
IEEE TRANSACTIONS ON MICROWAVE THEORY AND
TECHNIQUES, vol. MTT-30, no. 8, août 1982, pages
1247-1252, IEEE, New York, US; J.W. ARCHER: "A
solid-state low-noise receivers for 210-240 GHz"

ACTORUM AG

## Description

L'invention concerne un multiplicateur de fréquence tel que ceux utilisés pour les télécommunications par ondes millimétriques pour réaliser une source de signal hyperfréquence de très grande stabilité.

La réalisation des faisceaux hertziens en ondes millimétriques nécessite des sources hyperfréquences verrouillées en phase, modulables en fréquence, capables de délivrer quelques dizaines de milliwatts, et qui puissent fonctionner correctement dans la gamme de température de − 30 à + 70° Celsius. Il est connu de réaliser de telles sources à des fréquences de l'ordre 4 GHz, par contre il n'est pas possible de réaliser de telles sources à une fréquence de l'ordre de 40 GHz au moyen d'un oscillateur fonctionnant directement à cette fréquence. C'est pourquoi une technique connue consiste, par exemple, à combiner un multiplicateur de fréquence par 10 à une source de signal à 4 GHz, verrouillée en phase, pour obtenir un signal à 40 GHz verrouillé en phase. Ce procédé permet d'obtenir une stabilité en fréquence bien meilleure que celle d'un oscillateur à diode GUNN par exemple, fonctionnant directement à la fréquence de 40 GHz.

Il est connu de réaliser un multiplicateur par 10 recevant un signal incident de fréquence 4 GHz et fournissant un signal de sortie de fréquence 40 GHz, au moyen d'une diode à semi-conducteur de type IMPATT VARISELF par exemple, en appliquant le signal incident à la diode par l'intermédiaire d'un filtre passe-bas et adaptateur d'impédance évitant la remontée des fréquences harmoniques vers la source du signal incident; en recueillant la dixième harmonique générée par la diode au moyen d'une cavité accordée fixe contenant la diode, celle-ci ayant une position réglable dans cette cavité afin d'obtenir le fonctionnement donnant le meilleur rendement. Le filtre passe-bas adaptateur d'impédance comporte en général un transformateur dont le réglage, très délicat, doit être ajusté sur chaque exemplaire de multiplicateur. Le rendement obtenu avec les dispositifs connus comportant une diode IMPATT est de l'ordre de 5% dans cet exemple, et de 1 ou 2% avec une diode de type SNAP OFF (voir aussi le document US-A-2 408 420). L'objet de l'invention est de remédier à ce faible rendement, tout en réduisant au minimum le nombre des réglages à faire sur le multiplicateur.

Selon l'invention, un multiplicateur de fréquence, pour ondes millimétriques, comportant:

– une entrée coaxiale (1) pour recevoir un signal incident dont la fréquence est à multiplier;

– un guide d'onde rectangulaire (15, 37), dont une première extrémité (15) constitue une sortie du multiplicateur;

– une diode à semi-conducteur (16), placée dans le guide d'onde (15, 37);

– un porte-diode (17), sur lequel une première borne de la diode (15) est fixée;

– une cavité (31) située dans une paroi du guide (15, 37), à l'endroit où est placée la diode (16), cette cavité (31) étant accordée sur la fréquence harmonique souhaitée;

– un piston (18) de réglage de la cavité (31), de section circulaire centrée sur le porte-diode (17), coulissant le long de celui-ci, et immobile en rotation;

– au moins un piston de court-circuit (30, 32) fermant au moins partiellement une seconde extrémité (37) du guide;

est caractérisé en ce que:

– le porte-diode (17) est immobile en rotation et mobile en translation le long d'un axe parallèle au petit côté du guide d'onde (15, 37) et situé dans le plan de symétrie de celui-ci;

et en ce qu'il comporte en outre:

– un filtre passe-bas et adaptateur d'impédance (8 à 14 et 60), mobile en translation le long du même axe que le porte-diode (17), ayant une sortie (14) en contact avec une seconde borne de la diode (16); ayant une bande passante au moins égale à la fréquence du signal incident; et ayant une entrée couplée à l'entrée coaxiale (1);

– un dispositif élastique (4) reliant l'entrée coaxiale (1) à une entrée du filtre (8 à 14) quelle que soit la position de la diode (16) et effectuant une liaison électrique entre l'âme de l'entrée coaxiale et le filtre.

L'invention sera mieux comprise et d'autres détails apparaîtront à l'aide de la description ci-dessous et des figures l'accompagnant:

– la figure 1 représente une vue en coupe d'un exemple de réalisation du multiplicateur selon l'invention;

– les figures 2 à 6 représentent des vues de diverses parties de cet exemple.

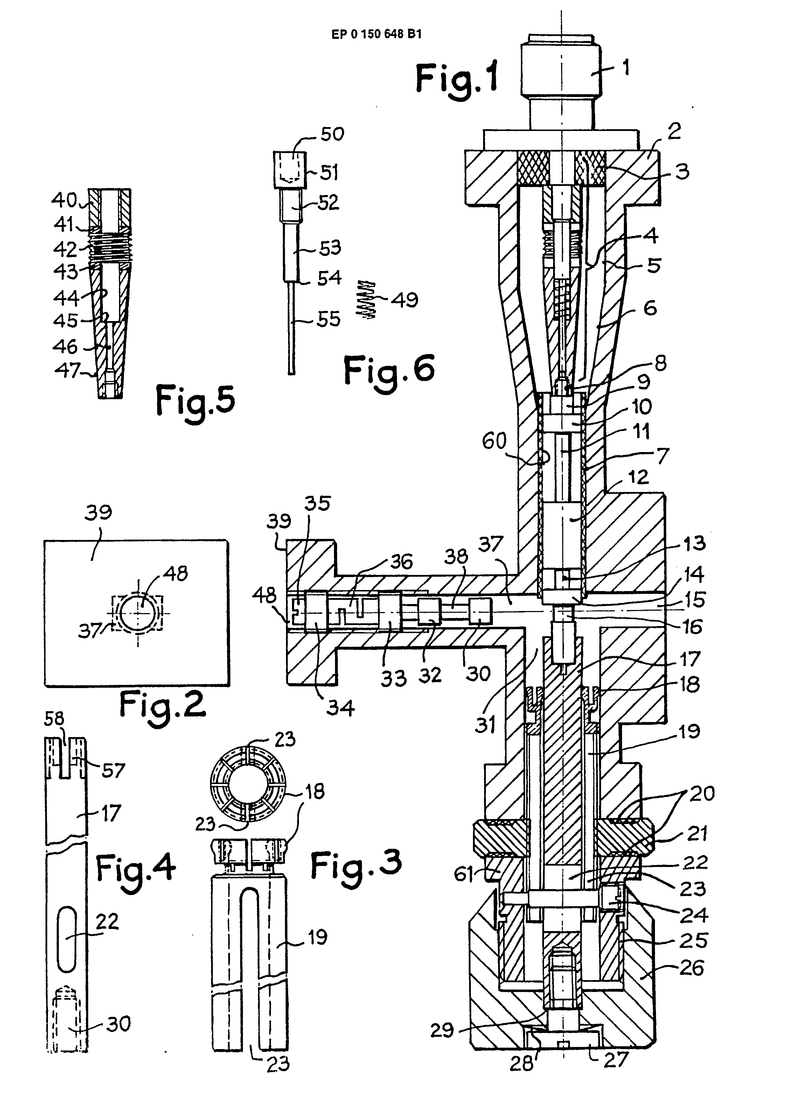

La figure 1 représente un exemple de réalisation où le signal incident, dans la fréquence est 4 GHz, est appliqué au multiplicateur par une entrée coaxiale constituée d'une prise coaxiale 1 ayant une embase fixée sur le corps 2 du multiplicateur par quatre vis non représentées. Sous cette embase, le corps 2 comprend un trou cylindrique 5 se prolongeant par un cône 6 jusqu'à un trou cylindrique 7 de diamètre inférieur au diamètre du trou 5. Les trous 5, 6 et 7 ont un même axe de symétrie de révolution. Le conducteur de l'âme de la prise coaxiale 1 dépasse de l'embase de cette prise et est soudée dans un trou, non représenté sur la figure 1, percé dans une première extrémité d'un dispositif élastique 4. Cette première extrémité est centrée dans le trou 5 par une pièce en téflon 3. Une seconde extrémité du dispositif élastique 4 comporte un trou fileté dans lequel est vissée une tige filetée 8 constituant l'entrée d'un filtre passe-bas et adaptateur d'impédance constitué d'une pièce métallique 8 à 14 et d'un tube de téflon 60 qui l'entoure avec un ajustage serré. Le dispositif élastique 4 relie électriquement l'âme de la prise coaxiale 1 à ce filtre en ayant une impédance de 50 ohms uniforme, et en exerçant en permanence une pression sur ce filtre qui est libre de se déplacer longitudinalement dans le trou 7.

La pièce métallique du filtre est composée d'une série de cylindres taillés dans un même morceau de métal et ayant trois valeurs de diamètre distinctes. En partant de la première extrémité, cette pièce métallique comporte la tige filetée 8 mentionnée précédemment, un premier cylindre 9 de diamètre égal à celui de la seconde extrémité du dispositif élastique 4, un second cylindre 10 de diamètre égal au diamètre intérieur du tube 60, un troisième cylindre 11 de diamètre très inférieur au diamètre intérieur du tube 60, un quatrième cylindre 12 de diamètre égal au diamètre intérieur du tube 60, un cinquième cylindre 13 de diamètre très inférieur au diamètre intérieur du tube 60 et un sixième cylindre 14 de diamètre égal au diamètre intérieur du tube 60 et qui constitue la seconde extrémité et la sortie du filtre.

Le diamètre extérieur du tube 60 est légèrement inférieur au diamètre du trou 7 pour permettre un coulissement de l'ensemble du filtre dans le trou 7. Le trou conique 6 a pour fonction de réaliser une transition progressive entre le diamètre du trou 5 correspondant aux dimensions de la prise coaxiale 1 et le diamètre du trou 7 correspondant au diamètre du filtre, qui est légèrement inférieur au grand côté du guide.

La force exercée par le dispositif élastique 4 pousse le filtre de telle façon que son extrémité 14 appuie sur une première borne d'une diode 16 située dans l'axe de symétrie du filtre et du dispositif élastique 4. Une deuxième borne de la diode 16 est serrée à l'extrémité d'un porte-diode 17 ayant une forme cylindrique à section circulaire dont l'axe de symétrie est dans le prolongement de l'axe de symétrie du dispositif 4 et du filtre. La diode 16 est située à l'intérieur d'un guide d'onde dont l'axe est perpendiculaire à l'axe de symétrie du dispositif 4, du filtre, et du porte-diode 17. Ce guide d'onde comprend une première et une seconde partie, 37 et 15, situées de part et d'autre de la diode 16 et celle-ci est située dans le plan médian du guide d'onde.

La première partie 37 du guide d'onde est partiellement fermée par une pièce de métal comportant un premier cylindre 30 de diamètre inférieur à la largeur du guide d'onde, un second cylindre 38 de diamètre inférieur au diamètre du cylindre 30, un troisième cylindre 32 identique au cylindre 30 et relié à celui-ci par le second cylindre 38. Le cylindre 32 est solidaire d'une vis auto-serrante constituée d'une tête de vis 35, d'un premier cylindre fileté 34, et d'un second cylindre fileté 33, reliés par une tige cylindrique 36. Les cylindres 34, 33, 32, 38, 30 et la tige 36 ont un axe de symétrie commun.

La tige 36 comporte deux coupures partielles perpendiculaires à l'axe de symétrie et qui donnent à cette tige 36 une certaine élasticité longitudinale. Lors de sa mise en place cette tige 36 est comprimée pour qu'elle exerce une force tendant à écarter les cylindres filetés 33 et 34 pour immobiliser ceux-ci dans un trou fileté 48. Ce dernier est réalisé dans le prolongement de la portion de guide 37 et a une section circulaire de diamètre égal à la largeur du guide, afin de permettre l'introduction des cylindres 30 et 32. Ce trou fileté 48 débouche sur une face plane 39 perpendiculaire à l'axe de symétrie commun à ce trou fileté 48 et au guide d'onde 37, 15.

La figure 2 représente une vue de la face plane 39 avec le trou fileté 48 et la première portion 37 du guide d'onde représenté en pointillés. La tête de vis 35 ne dépasse pas à l'extérieur du trou fileté 48, pour permettre de fixer sur la face plane 36 un dissipateur de chaleur. Les cylindres filetés 33 et 34, et la tige 36, constituent un dispositif de réglage de la position des cylindres 30 et 32 ne possédant pas de jeu et ne nécessitant pas de contre-écrou pour l'immobiliser, ce qui simplifie beaucoup le réglage. Les cylindres 30 et 32 constituent, du point de vue des ondes hyperfréquences, des courts-circuits mobiles. Le réglage de leur position permet de régler au mieux la transition entre le guide d'onde 37, 15 et la ligne coaxiale alimentant la diode 16, constituée par le dispositif élastique 4 et le filtre 8 à 14 et 60.

Ce filtre passe-bas et adaptateur a pour fonctions, d'une part, d'éviter la remontée de signaux harmoniques vers la source à 4 GHz et, d'autre part d'adapter l'impédance de la ligne coaxiale venant de la source à l'impédance de la diode 16. Dans cet exemple le filtre réalise une adaptation 50 ohms-8 ohms, et il a une bande passante légèrement supérieure à 4 GHz. Ce type de filtre est connu et sa réalisation est à la portée de l'homme de l'art. Il présente l'avantage d'être réalisable en série sans nécessiter un réglage sur chaque exemplaire.

Autour du porte-diode 17 est ménagée une cavité cylindrique 31, à section circulaire de diamètre légèrement supérieur au grand côté du guide 15-37, creusée dans le corps 2, ayant pour axe de symétrie l'axe de symétrie du support-diode 17, et qui est fermée par un court-circuit mobile 18 solidaire d'un cylindre métallique 19 coulissant le long du porte-diode 17. Le porte-diode 17 et le cylindre 19 sont immobilisés en rotation par une vis goupille 24 qui les traverse et qui est fixe. Le cylindre 19 porte un filetage qui est vissé dans le filetage d'une roue moletée 21, permettant de régler la position du court-circuit 18.

La roue 21 est libre en rotation autour de l'axe de symétrie du porte-diode 17 et du cylindre 19 mais est immobilisée en translation. Elle porte sur ces deux flancs des garnitures 20 en téflon qui assurent un frottement doux sur deux surfaces d'appuis, dont l'une est usinée sur le corps 2 et l'autre dans une pièce 61 constituant une cage contenant la roue 21 et qui est fixée au corps 2 par quatre vis non représentées. La vis-goupille 24 possède une tête filetée, qui est vissée dans un trou fileté de cette pièce 61.

La figure 3 représente deux vues plus détaillées du court-circuit 18 et du cylindre 19. Le court-circuit 18 comprend deux couronnes formées de segments souples. Une couronne extérieure assure le contact sur la paroi constituée par le corps 2 du multiplicateur et une couronne intérieure assure le contact avec la paroi constituée par le porte-diode 17. Le cylindre 19 est fileté sur toute sa surface mais il comporte deux trous 23 diamétralement opposés, allongés le long d'une génératrice, et dont la largeur est égale exactement au diamètre de la vis-goupille 24. La longueur de trous 23 est très supérieure à ce diamètre, elle permet donc une translation du cylindre 19 le long de son axe. Par contre, sa largeur étant égale au diamètre de la vis-goupille 24, le cylindre 19 est immobilisé en rotation. En agissant sur la roue moletée 21 un opérateur peut déplacer le court-circuit 18 pour régler la résonance de la cavité 31 sur une fréquence harmonique déterminée, par exemple sur la fréquence 40 GHz. L'absence de rotation du court-circuit 18 permet des réglages stables et répétables.

Sur la figure 1, le porte-diode 17 est solidaire en translation, mais pas en rotation, d'un bouton moleté 26 fixé à l'extrémité opposée à celle où est fixée la diode 16. A cette extrémité le porte-diode 17 comporte un trou fileté situé sur son axe de symétrie et dans lequel est vissée une vis 27. Le bouton 26 est serré contre le porte-diode 17 par une rondelle élastique 28 placée entre lui et la vis 27. La rondelle élastique 28 permet de maintenir le bouton 26 libre en rotation autour de la tige de la vis 27 tout en entraînant le porte-diode 17 en translation quand le bouton 26 est déplacé. La vis 27 comporte un épaulement 29 sur sa tige afin de pouvoir la rendre solidaire du porte-diode 17 en la serrant dans le trou fileté du porte-diode 17. Le bouton 26 est vissé dans un filetage 25 effectué sur une partie cylindrique de la pièce 61, avec pour axe de symétrie l'axe du porte-diode 17.

La figure 4 montre une vue plus détaillée du porte-diode 17. Sa première extrémité comporte un trou cylindrique 57 muni de quatre fentes 58, plus profondes que le trou 57 et constituant une pince pour maintenir la seconde borne de la diode 16. L'autre extrémité est munie d'un trou fileté 30 pour recevoir la partie filetée de la tige de la vis 27. Un trou oblong 22 traverse le porte-diode 17 perpendiculairement à son axe de symétrie. Il a une largeur exactement égale au diamètre de la vis-goupille 24, pour empêcher toute rotation du porte-diode 17, et il a une longueur, correspondant à une génératrice, très supérieure au diamètre de la vis-goupille 24 et permettant une certaine course de réglage pour la position de la diode 16 dans le guide d'onde.

Les figures 5 et 6 représentent les pièces constituant le dispositif élastique 4. Il comprend deux parties principales et un ressort 49 qui ont un axe de symétrie de révolution commun. La figure 5 montre une coupe d'une première partie qui constitue l'extérieur du dispositif 4. La figure 6 montre une vue non coupée d'une seconde partie qui constitue l'intérieur du dispositif 4.

Sur la figure 5 la première partie est constituée d'une première entretoise 40, d'une pièce intermédiaire 41, d'un soufflet 42, d'une pièce intermédiaire 43, et d'une seconde entretoise 47, soudées les unes aux autres dans cet ordre, par des soudures à l'étain. L'entretoise 40 comporte un trou fileté percé selon son axe de symétrie. La seconde entretoise 47 comporte deux trous, 44 et 46, de diamètres différents et percés selon son axe de symétrie. Le trou le plus grand, 44, est percé du côté où l'entretoise 47 est soudée à la pièce intermédiaire 43 et son diamètre correspond au diamètre du ressort 49 qui est un ressort à boudin placé dans ce trou 44. Le trou de diamètre le plus faible, 46, est percé à l'autre extrémité, de l'entretoise 47. Il comporte un filetage sur une partie de sa longueur, permettant de fixer la tige filetée 9 du filtre passe-bas et adaptateur. Ce trou 46 débouche dans le précédent, 44, en formant un épaulement 45 sur lequel s'appuie le ressort 49.

Le soufflet 42 est constitué d'un alliage métallique très souple. Il est vendu dans le commerce avec les pièces intermédiaires 41 et 43 qui constituent ses extrémités, sous la référence TOMBAC SK6307 par la Société SERVO METER (U.S.A.). Après le soudage à l'étain de l'entretoise 40 sur la pièce intermédiaire 41 et de l'entretoise 47 sur la pièce intermédiaire 43, l'ensemble est recouvert d'une couche d'or, comme d'ailleurs l'ensemble des pièces métalliques du multiplicateur, excepté le ressort 49.

Sur la figure 6, la seconde partie du dispositif élastique 4 est constituée de quatre cylindres de diamètre différents taillés dans une même pièce de métal. Un premier cylindre 51 est percé d'un trou borgne, non fileté, selon son axe de symétrie et dont le diamètre est légèrement supérieur au diamètre du conducteur de l'âme de la prise coaxiale 1. Ce conducteur est soudé dans ce trou par une soudure à l'étain. Le diamètre extérieur du cylindre 51 est égal au diamètre du trou de la pièce de centrage 3 en téflon.

Un second cylindre, 52, fileté, a un diamètre correspondant à celui du trou fileté de l'entretoise 40 car la première partie du dispositif 4 est vissée sur ce cylindre 52. La longueur du cylindre 52 est égale à la longueur de l'entretoise 40. Un troisième cylindre, 53, a une surface lisse de diamètre égal au diamètre des trous traversant les pièces intermédiaires 41 et 43 et une longueur supérieure à la longueur maximale du soufflet 42. Les pièces intermédiaires 41 et 43 peuvent glisser sur ce cylindre 53 avec un frottement doux, le soufflet 42 peut donc varier de longueur tout en étant maintenu parfaitement symétrique autour de son axe de symétrie de révolution.

Un quatrième cylindre, 55, a un diamètre égal au diamètre du trou 44 dans l'entretoise 46 pour coulisser avec un frottement doux dans ce trou 44. Ce cylindre 55 contribue à maintenir la rectitude de l'ensemble de la première partie du dispositif élastique 4. Ce cylindre 55 traverse le ressort à boudin 49 qui s'appuie sur l'épaulement 54 formé par le cylindre 53. Le ressort 49 s'appuyant sur cet épaulement 54 et sur l'épaulement 45, il tend à éloigner les extrémités 51 et 47 du dispositif élastique 4.

Ce dispositif élastique 4 conserve une parfaite rectitude quelque soit sa longueur, c'est-à-dire quelque soit le réglage de la position de la diode 16, pour éviter des variations de l'impédance de transmission le long de ce dispositif, il permet donc d'éviter des pertes de rendement du multiplicateur.

La diode 16 nécessite un dispositif de polarisation, non représenté sur les figures, qui est très classique et dont la réalisation est à la portée de l'homme de l'art. Dans le cas d'une diode IMPATT un générateur de courant continu alimente la diode 16 grâce à un T de polarisation branché entre la prise 1 et la source du signal incident à 4 GHz. Le T de polarisation comprend un filtre passe-bas permettant d'injecter un courant continu en dérivation sur l'entrée du multiplicateur.

L'invention ne se limite pas au mode de réalisation décrit et représenté. Il est à la portée de l'homme de l'art d'utiliser un autre type de diode, notamment une diode de type SNAP OFF, ou d'utiliser un court-circuit avec contacts à la place des cylindres 30 et 32 fermant partiellement la partie 37 du guide d'onde.

Le multiplicateur selon l'invention présente un rendement de 10% pour une multiplication par 10 à 40 GHz avec une diode IMPATT, et de 5% avec une diode SNAP OFF, ce qui est très supérieur au rendement des dispositifs multiplicateurs de l'art antérieur. Son rendement est meilleur notamment parce que le réglage de la cavité 31 permet un accord optimal de celle-ci. Son filtre passe-bas et adaptateur d'impédance ne nécessitant pas de réglage, les réglages sont donc plus simples que dans les dispositifs de l'art antérieur. Il est possible, par exemple, de couvrir la bande de fréquence de 30 à 45 Ghz en utilisant un signal incident de fréquence comprise entre 3,6 et 4,2 GHz, verrouillé en phase, et en utilisant les rangs de multiplication 7, 8, 9, 10, et 11, sélectionnés en réglant la cavité 31. Naturellement il est à la portée de l'homme de l'art d'adapter la réalisation pour couvrir une gamme de fréquence différente.

Le multiplicateur selon l'invention peut être appliqué notamment comme source d'ondes millimétriques pour des émetteurs de faisceaux hertziens.

**Revendications**

1. Multiplicateur de fréquence, pour ondes millimétriques, comportant:
— une entrée coaxiale (1) pour recevoir un signal incident dont la fréquence est à multiplier;
— un guide d'onde rectangulaire (15, 37) dont une première extrémité constitue une sortie du multiplicateur;
— une diode à semi-conducteur (16), placée dans le guide d'onde (15, 37);
— un porte-diode (17), sur lequel une première borne de la diode (15) est fixée;
— une cavité (31) située dans une paroi du guide (15, 37), à l'endroit où est placée la diode (16), cette cavité (31) étant accordée sur la fréquence harmonique souhaitée;
— un piston (18) de réglage de la cavité (31), de section circulaire centrée sur le porte-diode (17), coulissant le long de celui-ci, et immobile en rotation;
— au moins un piston de court-circuit (30, 32) fermant au moins partiellement une seconde extrémité (37) du guide;

caractérisé en ce que:
— le porte-diode (17) est immobile en rotation et mobile en translation le long d'un axe parallèle au petit côté du guide d'onde (15, 37) et situé dans le plan de symétrie de celui-ci;
et en ce qu'il comporte en outre:
— un filtre passe-bas et adaptateur d'impédance (8 à 14 et 60), mobile en translation le long du même axe que le porte-diode (17), ayant une sortie (14) en contact avec une seconde borne de la diode (16); ayant une bande passante au moins égale à la fréquence du signal incident; et ayant une entrée couplée à l'entrée coaxiale (11);
— un dispositif élastique (4) reliant l'entrée coaxiale (1) à une entrée du filtre (8 à 14) quelle que soit la position de la diode (16) et effectuant une liaison électrique entre l'âme de l'entrée coaxiale et le filtre.

2. Multiplicateur selon la revendication 1, caractérisé en ce que le porte-diode (17) a une forme cylindrique à section circulaire.

3. Multiplicateur selon la revendication 1, caractérisé en ce que le porte-diode (17) est solidaire en translation et libre en rotation par rapport à un bouton de réglage (26) vissable sur un pas de vis fixe (25); en ce qu'il comporte un trou (22) traversé par une goupille (24) fixe et perpendiculaire à l'axe de symétrie du porte-diode (17), ce trou (22) ayant une section de largeur égale au diamètre de la goupille (24) pour immobiliser le porte-diode (17) en rotation, et une longueur supérieure à ce diamètre pour permettre la translation du porte-diode (17).

4. Multiplicateur selon la revendication 1, caractérisé en ce que le piston (18) de réglage de la cavité (31) est solidaire d'un cylindre (19) à section circulaire, comportant un filetage extérieur vissé dans une roue moletée (21) libre en rotation et immobile en translation, et comportant un trou (23) traversé par une goupille (24), ce trou ayant une section de la largeur égale au diamètre de la goupille (24) pour empêcher une rotation du cylindre (19), et de longueur supérieure à ce diamètre pour permettre la translation du cylindre (19).

5. Multiplicateur selon la revendication 1, caractérisé en ce que le dispositif élastique (4) reliant l'entrée coaxiale à l'entrée coaxiale (1) à l'entrée du filtre (8 à 14) comporte une première et seconde partie ayant un axe de symétrie de révolution confondu avec l'axe de translation de la diode (16), la première partie (40 à 47) coulissant à l'extérieur de la seconde (50 à 55), une première extrémité (40) de la première partie (40 à 47) étant solidaire de l'âme de l'entrée coaxiale (1), une seconde extrémité (47) étant solidaire de l'entrée du filtre (8 à 14), et un soufflet (42) cylindrique et conducteur étant prévu entre ces deux extrémités (40 et 47) pour les relier électriquement quelle que soit la distance entre les deux extrémités (40 et 47); la seconde partie (50 à 55) étant rigide, solidaire de l'âme de l'entrée coaxiale (1) et comportant des parties cylindriques (53, 55) pour guider en translation le soufflet (42) et la seconde extrémité (47) de la première partie (40 à 47) afin de les maintenir parfaitement dans leur axe de symétrie;

et en ce que le dispositif élastique (4) comporte en outre: un ressort à boudin (49) placé à l'intérieur de la seconde extrémité (47) de la première partie (40 à 47) le long de son axe de symétrie, s'appuyant sur un épaulement de cette seconde extrémité (47) et sur un épaulement (54) de la première partie et exerçant une pression tendant à écarter les deux extrémités (40 et 47) de la première partie et à déplacer le filtre (8 à 14 et 60) en translation, afin de maintenir la sortie (14) du filtre (8 à 14 et 60) en contact avec la seconde borne de la diode (16) quelle que soit la position de la diode (16).

## Claims

1. A frequency multiplier for millimetre waves comprising:
– a coaxial input (1) for receiving an incident signal, whose frequency is to be multiplied;
– a square waveguide (15, 37) whereof a first end (15) constitutes an output of the multiplier;
– a semiconductor diode (16) placed in the waveguide (15, 37);
– a diode holder (17) to which is fixed a first terminal of the diode (15);
– a cavity (31) located in one wall of the guide (15, 37), at the location of the diode (16), said cavity (31) being tuned to the desired harmonic frequency;
– a plunger (18) regulating the cavity (31) and having a circular cross-section centred on the diode holder (17), which plunger slides along the latter and is stationary in rotation;
– at least one short-circuiting plunger (30, 32) at least partly closing a second end (37) of the guide;
  characterized in that:
– the diode holder (17) is stationary in rotation and mobile in translation along an axis parallel to the small side of the waveguide (15, 37) and located in the plane of symmetry thereof;
  and that it further comprises:
– an impedance matching low pass filter (8 to 14 and 60) mobile in translation along the same axis as the diode holder (17) and having an output (14) in contact with a second terminal of the diode (16); having a pass band at least equal to the frequency of the incident signal; and having an input coupled to the coaxial input (1),
– and elastic device (4) connecting said coaxial input (1) to an input of the filter (8 to 14), whatever the position of the diode (16) may be and ensuring an electric connection between the central conductor of the coaxial input and the filter.

2. A multiplier according to claim 1, characterized in that the diode holder (17) has a cylindrical shape and a circular cross-section.

3. A multiplier according to claim 1, characterized in that the diode holder (17) is integral in translation and free in rotation with respect to a control button (26) which can be screwed onto a fixed screw thread (25), that it comprises a hole (22) traversed by a fixed pin (24) and perpendicular to the axis of symmetry of the diode holder (17), said hole (22) having a section of width equal to the diameter of the pin (24) in order to immobilize the diode holder (17) in rotation, and a length exceeding said diameter to permit the translation of the diode holder (17).

4. A multiplier according to claim 1, characterized in that the regulating plunger (18) of the cavity (31) is integral with a cylinder (19) having a circular cross-section and an external thread screwed into a knurled wheel (21) which is free in rotation and immobile in translation, whilst having a hole (23) traversed by a pin (24), said hole having a section of width equal to the diameter of the pin (24) in order to prevent a rotation of the cylinder, whilst its length exceeds this diameter in order to permit the translation of the cylinder (19).

5. A multiplier according to claim 1, characterized in that the elastic device (4) connecting the coaxial input (1) to the input of the filter (8 to 14) has a first and a second part with an axis of symmetry of revolution coinciding with the translational axis of the diode (16), the first part (40 to 47) sliding externally of the second (50 to 55), a first end (40) of the first part (40 to 47) being integral with the core of the coaxial input (1), a second end (47) being integral with the filter input (8 to 14), whilst a conductive cylindrical bellows (42) is located between these two ends (40 and 47) to electrically connect the same, no matter what the distance between said two ends; the second part (50 to 55) being rigid, integral with the core of the coaxial input (1) and having cylindrical portions (53, 55) for guiding in translation the bellows (42) and the second end (47) of the first part (40 to 47) in order to perfectly maintain them in their axis of symmetry;
and that the elastic device (4) also comprises: a spiral spring (49) placed within the second end (47) of the first part (40 to 47) along its axis of symmetry, bearing on a shoulder of said second end (47) and of a shoulder (54) of the second part and whilst exerting a pressure tending to move the two ends (40 and 47) of the first part apart and displace the filter in translation (8 to 14 and 60), in order to keep the output (14) of the filter (8 to 14 and 60) in contact with the second terminal of the diode (16), no matter what the position of the diode (16).

## Patentansprüche

1. Frequenzvervielfacher für Millimeterwellen, mit:
– einem koaxialen Eingang (1) zum Empfang eines einfallenden Signals, dessen Frequenz vervielfacht werden soll;
– einem Rechteck-Wellenleiter (15, 37), von dem ein erstes Ende einen Ausgang des Vervielfachers bildet;
– einer Halbleiterdiode (16), die im Wellenleiter (14, 37) sitzt;
– einem Diodenhalter (17), auf dem ein erster Anschluss der Diode (15) befestigt ist;
– einem Hohlraum (31) in einer Wand des Wellenleiters (15, 37) an der Stelle, wo die Diode (16) sitzt, wobei der Hohlraum (31) auf die gewünschte harmonische Frequenz abgestimmt ist;

– einem Steuerkolben (18) für den Hohlraum (31), der einen kreisförmigen Querschnitt besitzt und um den Diodenhalter (17) zentriert ist sowie entlang des Halters gleitet, ohne zu drehen;

– mindestens einem Kurzschlussschieber (30, 32), der mindestens teilweise ein zweites Ende (37) des Wellenleiters verschliesst;

dadurch gekennzeichnet, dass

– der Diodenhalter (17) drehfest, aber längsverschieblich entlang einer Achse ist, welche parallel zur kleinen Seite des Wellenleiters (15, 37) verläuft und in der Symmetrieachse derselben liegt;

und dass er weiter aufweist:

– ein impedanzanpassendes Tiefpassfilter (8 bis 14 und 60), das entlang der gleichen Achse längsverschieblich ist wie der Diodenhalter (17), mit einem Ausgang (14), der in Kontakt mit dem zweiten Anschluss der Diode (16) steht, mit einem Durchlassband, das mindestens der Frequenz des einfallenden Signals gleicht; und mit einem Eingang, der an den koaxialen Eingang (1) angekoppelt ist;

– eine elastische Vorrichtung (4), welche den koaxialen Eingang (1) mit einem Eingang des Filters (8 bis 14) verbindet, unabhängig von der Position der Diode (16), und eine elektrische Verbindung zwischen der Seele des koaxialen Eingangs und dem Filter herstellt.

2. Vervielfacher nach Anspruch 1, dadurch gekennzeichnet, dass der Diodenhalter (17) eine zylindrische Form und Kreisquerschnitt besitzt.

3. Vervielfacher nach Anspruch 1, dadurch gekennzeichnet, dass der Diodenhalter (17) nicht längsverschiebbar, aber drehbeweglich gegenüber einem Steuerknopf (26) ist, der auf einen feststehenden Gewindegang (25) aufschraubbar ist, dass der Halter ein Loch (22) aufweist, das von einem feststehenden, senkrecht zur Symmetrieachse des Diodenhalters (17) verlaufenden Stift (24) durchquert wird, wobei das Loch (22) einen Querschnitt aufweist, dessen Breite dem Durchmesser des Stiftes (24) zur Blockierung des Diodenhalters (17) gegen Drehung gleicht und dessen Länge grösser als dieser Durchmesser ist, um die Längsverschiebung des Diodenhalters (17) zu ermöglichen.

4. Vervielfacher nach Anspruch 1, dadurch gekennzeichnet, dass der Steuerkolben (18) für den Hohlraumes (31) mit einem Zylinder (19) mit kreisförmigem Querschnitt fest verbunden ist, welcher ein äusseres Gewinde besitzt, das in ein drehbewegliches, nicht längsverschiebliches Rändelrad (21) eingeschraubt ist, und welcher ein von einem Stift (24) durchquertes Loch (23) besitzt, das einen Querschnitt aufweist, dessen Breite dem Durchmesser des Stiftes (24) zur Verhinderung der Drehung des Zylinders (19) entspricht, und dessen Länge grösser als dieser Durchmesser ist, um die Längsverschiebung des Zylinders (19) zu ermöglichen.

5. Vervielfacher nach Anspruch 1, dadurch gekennzeichnet, dass die den koaxialen Eingang (1) mit dem Eingang des Filters (8 bis 14) verbindende elastische Vorrichtung einen ersten und einen zweiten Teil mit einer Drehsymmetrieachse besitzt, welche mit der Längsverschiebungsachse der Diode (16) zusammenfällt, wobei der erste Teil (40 bis 47) entlang der Aussenseite des zweiten (50 bis 55) gleitet, ein erstes Ende (40) des ersten Teiles (40 bis 47) fest mit der Seele des koaxialen Einganges (1) verbunden und ein zweites Ende (47) fest mit dem Eingang des Filters (8 bis 14) verbunden ist; dass die Vorrichtung einen zylindrischen und leitenden Balg (42) umfasst, der zwischen den beiden Enden (40 und 47) zur elektrischen Verbindung derselben unabhängig vom Abstand zwischen den beiden Enden (40 bis 47) vorgesehen ist; und dass der zweite Teile (50 bis 55) starr und fest mit der Seele des koaxialen Eingangs (1) verbunden ist und zylindrische Abschnitte (53, 55) aufweist, die den Balg (42) und das zweite Ende (47) des ersten Teils (40 bis 47) bei der Längsverschiebung führen, um sie vollkommen in ihrer Symmetrieachse zu halten;

– und dass die elastische Vorrichtung (4) weiter eine Schraubenfeder (49) aufweist, welche im Inneren des zweiten Endes (47) des ersten Teiles (40 bis 47) längs seiner Symmetrieachse gelagert ist, sich auf einer Schulter des zweiten Endes (47) und auf einer Schulter (54) des ersten Teiles abstützt und eine Druckkraft ausübt, welche die beiden Enden (40 und 47) des ersten Teils voneinander zu entfernen und das Filter (8 bis 14 und 60) längs zu verschieben sucht, um den Ausgang (14) des Filters (8 bis 14 und 60) in Kontakt mit dem zweiten Anschluss der Diode (16) zu halten, unabhängig von der Position der Diode (16).

Fig.1

Fig.5

Fig.6

Fig.2

Fig.4

Fig.3